# EUROPEAN PATENT APPLICATION

(11) **EP 2 887 391 A2**
(43) Date of publication of application: **24.06.2015**
(21) Application number: 14198177.9
(22) Date of filing: 16.12.2014
(51) Int. Cl.: H01L 23/373

(54) **Oriented flexible heat-conducting material, and forming process and application thereof**

(30) Priority: 23.12.2013 CN 201310719429
(71) Applicant: Huawei Technologies Co., Ltd., Longgang District Shenzhen, Guangdong 518129 (CN); Shenzhen Bornsun Industry Limited Company, Shenzhen City, Guangdong (CN); Graduate School At Shenzhen, Tsinghua University, Guangdong 518055 (CN)
(72) Inventor: Zhao, Cuifeng, Shenzhen City (CN); Zhou, Xiaosong, 518129 Shenzhen (CN); Xu, Yan, 518129 Shenzhen (CN); Du, Hongda, 518055 Shenzhen (CN)
(74) Representative: Goddar, Heinz J.

(57) **Abstract**

The present invention provides an oriented flexible heat-conducting material, where main ingredients of the oriented flexible heat-conducting material are silicone rubber and anisotropic heat-conducting filler. Multiple continuous heat-conducting paths that are parallel to each other are formed in the oriented flexible heat-conducting material, and the heat-conducting paths are formed by continuously arranging the anisotropic heat-conducting filler, filled in the silicone rubber, in lines in a heat-conducting path direction. The oriented flexible heat-conducting material has a desirable heat-conducting property in a specific direction and has desirable flexibility, can be in desirable contact with an interface to produce quite low interface thermal resistance, and can greatly improve a heat dissipation effect. Embodiments of the present invention further provide a forming process and an application of the oriented flexible heat-conducting material.

## Description

### TECHNICAL FIELD

The present invention relates to the field of flexible heat-conducting materials, and in particular, to an oriented flexible heat-conducting material, and a forming process and an application thereof.

### BACKGROUND

With the continuous upgrading of electronic products and continuous improvement of integration technologies, high density of semiconductors in a product leads to a sharp increase of accumulation of generated heat, and a concentration of heat leads to a decrease of the reliability of the product. Therefore, an efficient heat dissipation method is very important to the electronic products.

### SUMMARY

In view of this, a first aspect of embodiments of the present invention provides an oriented flexible heat-conducting material, where the oriented flexible heat-conducting material has a desirable heat-conducting property in a specific direction, and can greatly improve a heat dissipation effect.

According to a first aspect, an embodiment of the present invention provides an oriented flexible heat-conducting material, where multiple continuous heat-conducting paths that are parallel to each other are formed in the oriented flexible heat-conducting material, and the heat-conducting paths are formed by continuously arranging anisotropic heat-conducting filler, filled in silicone rubber, in lines in a heat-conducting path direction.

Preferably, the silicone rubber includes a component A and a component B, where:
the component A includes polysiloxane containing two or more unsaturated bonds, where the unsaturated bonds are allyl groups or vinyl groups; and
the component B includes polysiloxane containing two or more silicon-hydrogen bonds.

Preferably, corresponding parts by weight of components of the oriented flexible heat-conducting material are that:
for the silicone rubber, the component A is 100 parts by weight, and the component B is 2 to 5 parts by weight; and
the anisotropic heat-conducting filler is 10 to 70 parts by weight.

Preferably, the oriented flexible heat-conducting material further includes one or more of the following materials:
a precious metal catalyst, an inhibitor, reinforcing filler used for improving a comprehensive mechanical property of the oriented flexible heat-conducting material, and an inorganic powder material used for enhancing a comprehensive heat-conducting property of the oriented flexible heat-conducting material.

Preferably, corresponding parts by weight of the precious metal catalyst, the inhibitor, the reinforcing filler and the inorganic powder material in the oriented flexible heat-conducting material are that:
the reinforcing filler is 0.1 to 8 parts by weight;
the precious metal catalyst is 0.1 to 7 parts by weight;
the inhibitor is 0.1 to 5 parts by weight; and
the inorganic powder material is 1 to 20 parts by weight.

Preferably, the reinforcing filler used for improving the comprehensive mechanical property of the oriented flexible heat-conducting material is white carbon black produced by using a precipitation method or white carbon black produced by a vapor phase method.

Preferably, the inorganic powder material used for enhancing the comprehensive heat-conducting property of the oriented flexible heat-conducting material is one or more of aluminum oxide, silicon dioxide, zinc oxide, boron nitride, silicon nitride, and silicon carbide.

Preferably, the precious metal catalyst is a platinum catalyst.

Preferably, the inhibitor is an acetylenic alcohol inhibitor.

Preferably, the anisotropic heat-conducting filler is one or more of expanded graphite, carbon fibers, carbon nanotubes, graphene nanosheets, and boron nitride nanosheets.

Preferably, a compression ratio of the cured silicone rubber is higher than 80%, and a crosslinking density of the cured silicone rubber is 0 to 70%.

According to the oriented flexible heat-conducting material provided in the first aspect of the embodiments of the present invention, an anisotropic heat-conducting material is used as heat-conducting filler, and the anisotropic heat-conducting filler is continuously arranged in lines in a specific direction, so as to form, in the specific direction, multiple continuous heat-conducting paths that are parallel to each other, so that the oriented flexible heat-conducting material has a desirable heat-conducting property in the specific direction, where a heat conductivity coefficient can reach above 15 W/(m·k). Meanwhile, the oriented flexible heat-conducting material has desirable flexibility, can be in desirable contact with an interface to produce quite low interface thermal resistance, and can greatly improve a heat dissipation effect. The oriented flexible heat-conducting material can be used in a heat dissipation cooling apparatus of a heat generating component.

According to a second aspect, an embodiment of the present invention provides a forming process of an oriented flexible heat-conducting material, including the following steps:
evenly mixing silicone rubber and anisotropic heat-conducting filler to form a sizing material, adding the sizing material into an oriented forming mold, applying a pressure in a direction perpendicular to a preset heat-conducting path, and then performing heating to vulcanize the sizing material, so as to obtain a sample on which orientation forming is performed, that is, the oriented flexible heat-conducting material, where in the oriented flexible heat-conducting material, multiple continuous heat-conducting paths that are parallel to each other are formed in a direction along the preset heat-conducting path, and the heat-conducting paths are formed by continuously arranging the anisotropic heat-conducting filler, filled in the silicone rubber, in lines in the direction along the preset heat-conducting path.

Preferably, a mold strip, in the direction along the preset heat-conducting path, of the oriented forming mold is a movable mold strip.

Preferably, the applied pressure is 10 to 40 MPa and a pressure applying time is 0.5 to 5 min.

The forming process of an oriented flexible heat-conducting material provided in the second aspect of the embodiments of the present invention has a simple process, is easy for mass production, and can implement great enhancement of a heat-conducting property, in a specific direction, of the oriented flexible heat-conducting material, and a heat conductivity coefficient, in a thickness direction, of the obtained oriented flexible heat-conducting material can reach above 15 W/(m·k).

According to a third aspect, an embodiment of the present invention provides an oriented flexible heat-conducting sheet, where the oriented flexible heat-conducting sheet is obtained by cutting the oriented flexible heat-conducting material described in the first aspect of the embodiments of the present invention, multiple continuous heat-conducting paths that are parallel to each other exist in a thickness direction of the oriented flexible heat-conducting sheet, and the heat-conducting paths are formed by continuously arranging anisotropic heat-conducting filler, filled in silicone rubber, in lines in a heat-conducting path direction.

The oriented flexible heat-conducting sheet provided in the third aspect of the embodiments of the present invention has an excellent heat-conducting property in a thickness direction, a heat conductivity coefficient of the oriented flexible heat-conducting sheet can reach above 15 W/(m·k), and the oriented flexible heat-conducting sheet can be applied in a heat dissipation system.

According to a fourth aspect, an embodiment of the present invention provides a heat dissipation system, including a heat generating element, a radiator and a heat-conducting sheet, where the heat-conducting sheet is the oriented flexible heat-conducting sheet provided in the third aspect of the embodiments of the present invention, the heat generating element is located on one side of the radiator, and the heat-conducting sheet is located between the heat generating element and the radiator in close contact, so that the heat generating element transfers, by using the heat-conducting sheet, heat to the radiator to dissipate the heat.

For the heat-conducting material, heat-conducting sheet or heat dissipation material in the foregoing embodiments, an anisotropic heat-conducting material used as heat-conducting filler is continuously arranged in lines in a specific direction, so as to form, in the specific direction, multiple continuous heat-conducting paths that are parallel to each other, so that the oriented flexible heat-conducting material has a desirable heat-conducting property in the specific direction.

Advantages of the embodiments of the present invention will be partially clarified in the following specification. A part of the advantages are apparent according to the specification, or may be learned from implementation of the embodiments of the present invention.

### BRIEF DESCRIPTION OF DRAWINGS

FIG. 1 is a three-dimensional view of an oriented forming mold according to an embodiment of the present invention; and
FIG. 2 is a sectional view of an oriented forming mold according to an embodiment of the present invention.

### DESCRIPTION OF EMBODIMENTS

The following descriptions are exemplary implementation manners of embodiments of the present invention. It should be noted that a person of ordinary skill in the art may make certain improvements and refinements without departing from the principle of the embodiments of the present invention and the improvements and refinements shall fall within the protection scope of the embodiments of the present invention.

The embodiments of the present invention are further described by using multiple embodiments in the following. The embodiments of the present invention are not limited to the following specific embodiments. Appropriate modifications can be made within the scope of the independent claims.

A first aspect of the embodiments of the present invention provides an oriented flexible heat-conducting material, where the oriented flexible heat-conducting material has a desirable heat-conducting property in a specific direction and has desirable flexibility, can be in desirable contact with an interface to produce quite low interface thermal resistance, can greatly improve a heat dissipation effect, and is used to solve the problems in the prior art that a flexible heat dissipation material does not have a feature of having an excellent heat-conducting property in a specific direction, but has high interface thermal resistance and a high price, and so on.

According to a first aspect, an embodiment of the present invention provides an oriented flexible heat-conducting material, where multiple continuous heat-conducting paths that are parallel to each other are formed in the oriented flexible heat-conducting material, and the heat-conducting paths are formed by continuously arranging anisotropic heat-conducting filler, filled in silicone rubber, in lines in a heat-conducting path direction.

The multiple continuous heat-conducting paths that are parallel to each other refer to that the anisotropic heat-conducting filler in the heat-conducting paths is continuously arranged in lines in directions that are parallel to each other, so that the heat-conducting paths are substantially parallel. The "being parallel to each other" does not refer to being strictly geometrically parallel, but refers to that overall extending trends of the multiple heat-conducting paths are parallel, but microscopically, on a small section that is cut off arbitrarily, the multiple heat-conducting paths may not be parallel to each other.

The silicone rubber in the embodiment of the present invention may be, but is not limited to, solid silicone rubber, phenyl silicone or liquid silicone.

Preferably, the silicone rubber includes a component A and a component B, where:
the component A includes polysiloxane containing two or more unsaturated bonds, where the unsaturated bonds are allyl groups or vinyl groups; and
the component B includes polysiloxane containing two or more silicon-hydrogen bonds.

Preferably, corresponding parts by weight of components of the oriented flexible heat-conducting material are that:
for the silicone rubber, the component A is 100 parts by weight, and the component B is 2 to 5 parts by weight; and
the anisotropic heat-conducting filler is 10 to 70 parts by weight.

Preferably, the oriented flexible heat-conducting material further includes one or more of the following materials:
a precious metal catalyst, an inhibitor, reinforcing filler used for improving a comprehensive mechanical property of the oriented flexible heat-conducting material, and an inorganic powder material used for enhancing a comprehensive heat-conducting property of the oriented flexible heat-conducting material.

Preferably, corresponding parts by weight of the precious metal catalyst, the inhibitor, the reinforcing filler and the inorganic powder material in the oriented flexible heat-conducting material are that:
the reinforcing filler is 0.1 to 8 parts by weight;
the precious metal catalyst is 0.1 to 7 parts by weight;
the inhibitor is 0.1 to 5 parts by weight; and
the inorganic powder material is 1 to 20 parts by weight.

The inorganic powder material mainly plays a role of further enhancing the comprehensive heat-conducting property of the flexible heat-conducting material; the reinforcing filler mainly plays a role of improving the comprehensive mechanical property of the flexible heat-conducting material; the inhibitor mainly plays a role of inhibiting pre-curing of the silicone rubber under a room temperature condition to achieve that a curing degree of the silicone rubber in different stages is controllable, so that the silicone rubber can keep desirable liquidity under the room temperature condition, which facilitates thorough stirring, and therefore, it is achieved that the silicone rubber and a heat-conducting filling material are evenly distributed; and the precious metal catalyst plays a role of accelerating crosslinking and curing of the silicone rubber.

Preferably, the anisotropic heat-conducting filler is one or more of expanded graphite, carbon fibers, carbon nanotubes, graphene nanosheets, and boron nitride nanosheets.

Preferably, a bulk density of the expanded graphite is 0.007 to 0.015 g/cm³; a diameter of the carbon fibers is 10 to 50 µm, and a length of the carbon fibers is 50 to 200 µm; a diameter of the carbon nanotubes is 30 to 100 nm, and a length of the carbon nanotubes is 1 to 20 µm; a thickness of the graphene nanosheet is 1 to 10 nm, and a length of the graphene nanosheets is 0.3 to 50 µm; and a thickness of the boron nitride nanosheet is 10 to 100 nm, and a length of the boron nitride nanosheets is 0.1 to 5 µm.

Preferably, the reinforcing filler used for improving the comprehensive mechanical property of the oriented flexible heat-conducting material is white carbon black produced by using a precipitation method or white carbon black produced by a vapor phase method.

Preferably, the inorganic powder material used for enhancing the comprehensive heat-conducting property of the oriented flexible heat-conducting material is one or more of aluminum oxide, silicon dioxide, zinc oxide, boron nitride, silicon nitride, and silicon carbide.

Preferably, the precious metal catalyst is a platinum catalyst.

Preferably, the inhibitor is an acetylenic alcohol inhibitor, which may be, for example, alkynyl cyclohexanol.

Preferably, a compression ratio of the cured silicone rubber is higher than 80%, and a crosslinking density of the cured silicone rubber is 0 to 70%.

According to the oriented flexible heat-conducting material provided in the first aspect of the embodiments of the present invention, an anisotropic heat-conducting material is used as heat-conducting filler, and the anisotropic heat-conducting filler is continuously arranged in lines in a specific direction, so as to form, in the specific direction, multiple continuous heat-conducting paths that are parallel to each other, so that the oriented flexible heat-conducting material has a desirable heat-conducting property in the specific direction, where a heat conductivity coefficient can reach above 15 W/(m·k). Meanwhile, the oriented flexible heat-conducting material has desirable flexibility, can be in desirable contact with an interface to produce quite low interface thermal resistance, and can greatly improve a heat dissipation effect. The oriented flexible heat-conducting material can be used in a heat dissipation cooling apparatus of a heat generating component.

According to a second aspect, an embodiment of the present invention provides a forming process of an oriented flexible heat-conducting material, including the following steps:
evenly mixing silicone rubber and anisotropic heat-conducting filler to form a sizing material, adding the sizing material into an oriented forming mold, applying a pressure in a direction perpendicular to a preset heat-conducting path, and then performing heating to vulcanize the sizing material, so as to obtain a sample on which orientation forming is performed, that is, the oriented flexible heat-conducting material, where in the oriented flexible heat-conducting material, multiple continuous heat-conducting paths that are parallel to each other are formed in a direction along the preset heat-conducting path, and the heat-conducting paths are formed by continuously arranging the anisotropic heat-conducting filler, filled in the silicone rubber, in lines in the direction along the preset heat-conducting path.

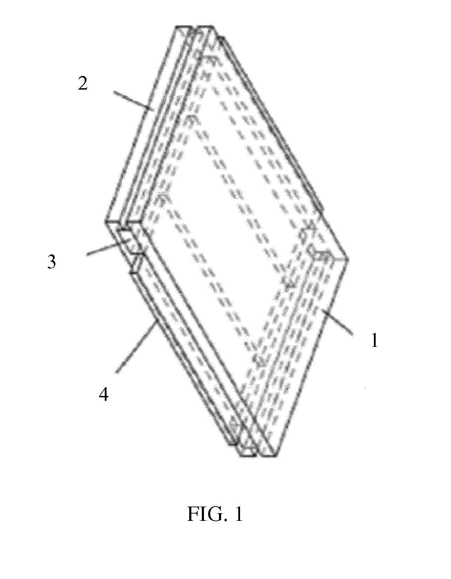

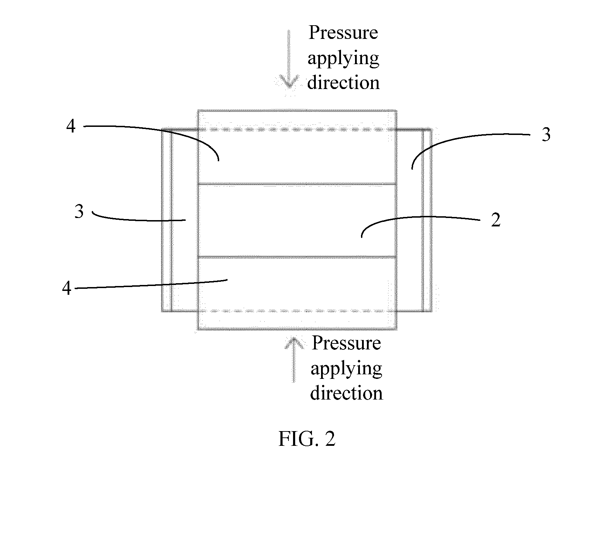

The oriented forming mold in the embodiment of the present invention is a self-made mold, where a three-dimensional view of the mold is shown in FIG. 1. FIG. 2 is a sectional view of the mold in the direction perpendicular to the preset heat-conducting path. In the figures, 1 is an upper mold plate, 2 is a lower mold plate, 3 is a fixed mold strip, and 4 is a movable mold strip. In a forming process, the sizing material is loaded into the oriented forming mold, the upper mold plate 1 is closed, pressures are simultaneously applied in directions perpendicular to the preset heat-conducting path, that is, two opposite directions parallel to the mold plates (pressure applying directions are shown in FIG. 2), so that the sizing material is pressed and formed, and after heating for vulcanization, the movable mold strip 4 is removed, the upper mold plate 1 is opened, and a sample is taken out, so that the oriented flexible heat-conducting material on which orientation forming is performed is obtained.

Preferably, the mold strip, in the direction along the preset heat-conducting path, of the oriented forming mold is a movable mold strip. An arrangement of the movable mold strip facilitates implementation of orientation forming.

Preferably, a manner of applying the pressure may be applying by using an oil pressure or an air pressure, where the pressure is 10 to 40 MPa, and a pressure applying time is 0.5 to 5 min.

Preferably, a temperature of the heating for vulcanization is 80 to 200°C, and a vulcanization time is 60 to 75 min.

Preferably, the sizing material further includes a precious metal catalyst, an inhibitor, reinforcing filler used for improving a comprehensive mechanical property of the oriented flexible heat-conducting material, and an inorganic powder material used for enhancing a comprehensive heat-conducting property of the oriented flexible heat-conducting material.

The silicone rubber, the anisotropic heat-conducting filler, the precious metal catalyst, the inhibitor, the reinforcing filler and the inorganic powder material are described in the first aspect of the embodiments of the present invention, and details are not repeatedly described herein.

The forming process of an oriented flexible heat-conducting material provided in the second aspect of the embodiments of the present invention has a simple process, is easy for mass production, and can implement great enhancement of a heat-conducting property, in a specific direction, of the oriented flexible heat-conducting material, and a heat conductivity coefficient, in the specific direction, of the obtained oriented flexible heat-conducting material can reach above 15 W/(m·k).

According to a third aspect, an embodiment of the present invention provides an oriented flexible heat-conducting sheet, where the oriented flexible heat-conducting sheet is obtained by cutting the oriented flexible heat-conducting material described in the first aspect of the embodiments of the present invention, multiple continuous heat-conducting paths that are parallel to each other exist in a thickness direction of the oriented flexible heat-conducting sheet, and the heat-conducting paths are formed by continuously arranging anisotropic heat-conducting filler, filled in silicone rubber, in lines in a heat-conducting path direction.

Specifically, a cutting process is: taking out an oriented flexible heat-conducting material sample that has underdone orientation forming from an oriented forming mold, and then cutting the sample along a direction parallel to a mold pressing direction to obtain an oriented flexible heat-conducting sheet with a required thickness, where multiple continuous heat-conducting paths that are parallel to each other exist in the thickness direction of the oriented flexible heat-conducting sheet, and the heat-conducting paths are formed by continuously arranging the anisotropic heat-conducting filler, filled in the silicone rubber, in lines in the heat-conducting path direction.

Preferably, a cutter with a V-shaped cutting edge is used for cutting.

The oriented flexible heat-conducting sheet provided in the third aspect of the embodiments of the present invention has an excellent heat-conducting property in a thickness direction, a heat conductivity coefficient of the oriented flexible heat-conducting sheet can reach above 15 W/(m·k), and the oriented flexible heat-conducting sheet can be applied in a heat dissipation system.

According to a fourth aspect, an embodiment of the present invention provides a heat dissipation system, including a heat generating element, a radiator and a heat-conducting sheet, where the heat-conducting sheet is the oriented flexible heat-conducting sheet provided in the third aspect of the embodiments of the present invention, the heat generating element is located on one side of the radiator, and the heat-conducting sheet is located between the heat generating element and the radiator in close contact, so that the heat generating element transfers, by using the heat-conducting sheet, heat to the radiator to dissipate the heat.

### Embodiment 1

A forming process of an oriented flexible heat-conducting material includes the following steps:
feeding 100 parts of vinyl group-capped polysiloxane, 5 parts of white carbon black prepared by using a vapor phase method, 10 parts of aluminum oxide, 5 parts of silicon-hydrogen bond-containing polysiloxane, and 0.2 part of alkynyl cyclohexanol into a kneading machine, performing kneading evenly, then adding 0.1 part of platinum catalyst and 40 parts of expanded graphite and performing kneading evenly to obtain a sizing material, taking out the sizing material, loading the sizing material into an oriented forming mold, closing an upper mold plate, simultaneously applying pressures in two opposite directions parallel to the mold plate for forming, where the applying pressure is 10 MPa and a time of 0.5 min is lasted for, then heating the sizing material for vulcanization (120°C, 60 min), and withdrawing the sizing material from a movable mold strip, opening the upper mold plate, and taking out a vulcanized sample on which orientation forming is performed, to obtain the oriented flexible heat-conducting material.

Preparation of a heat-conducting sheet: cutting the obtained oriented flexible heat-conducting material sample by using a cutter (with a V-shaped cutting edge) along a direction parallel to a mold pressing direction to obtain an oriented flexible heat-conducting sheet with a thickness of 3 mm.

### Comparison embodiment 1

A sizing material is prepared by using the same method in Embodiment 1, the sizing material is loaded into a common flat mold, the sizing material is pressurized for vulcanization (10 Mpa, 120°C, and 120s), and sheet formation is performed to obtain a heat-conducting sheet with a thickness of 3 mm.

### Embodiment 2

A forming process of an oriented flexible heat-conducting material includes the following steps:
feeding 100 parts of vinyl group-capped polysiloxane, 5 parts of white carbon black prepared by a vapor phase method, 5 parts of boron nitride, 3 parts of silicon-hydrogen bond-containing polysiloxane, and 0.2 part of alkynyl cyclohexanol into a kneading machine, performing kneading evenly, then adding 0.1 part of platinum catalyst and 40 parts of expanded graphite and performing kneading evenly to obtain a sizing material, taking out the sizing material, loading the sizing material into an oriented forming mold, closing an upper mold plate, simultaneously applying pressures in two opposite directions parallel to the mold plate for forming, where the applying pressure is 10 MPa and a time of 0.5 min is lasted for, then heating the sizing material for vulcanization (120°C, 60 min), and withdrawing the sizing material from a movable mold strip, opening the upper mold plate, and taking out a vulcanized sample on which orientation forming is performed, to obtain the oriented flexible heat-conducting material.

Preparation of a heat-conducting sheet: cutting the obtained oriented flexible heat-conducting material by using a cutter (with a V-shaped cutting edge) along a direction parallel to a mold pressing direction to obtain an oriented flexible heat-conducting sheet with a thickness of 3 mm.

### Comparison embodiment 2

A sizing material is prepared by using the same method in Embodiment 2, the sizing material is loaded into a common flat mold, the sizing material is pressurized for vulcanization (10 Mpa, 120°C, and 120s), and sheet formation is performed to obtain a heat-conducting sheet with a thickness of 3 mm.

### Embodiment 3

A forming process of an oriented flexible heat-conducting material includes the following steps:
feeding 100 parts of vinyl group-capped polysiloxane, 5 parts of white carbon black prepared by using a precipitation method, 5 parts of aluminum oxide, 4 parts of silicon-hydrogen bond-containing polysiloxane, and 0.2 part of alkynyl cyclohexanol into a kneading machine, performing kneading evenly, then adding 0.1 part of platinum catalyst and 45 parts of expanded graphite and performing kneading evenly to obtain a sizing material, taking out the sizing material, loading the sizing material into an oriented forming mold, closing an upper mold plate, simultaneously applying pressures in two opposite directions parallel to the mold plate for forming, where the applying pressure is 10 MPa and a time of 2 min is lasted for, then heating the sizing material for vulcanization (120°C, 60 min), and withdrawing the sizing material from a movable mold strip, opening the upper mold plate, and taking out a vulcanized sample on which orientation forming is performed, to obtain the oriented flexible heat-conducting material.

Preparation of a heat-conducting sheet: cutting the obtained oriented flexible heat-conducting material sample by using a cutter (with a V-shaped cutting edge) along a direction parallel to a mold pressing direction to obtain an oriented flexible heat-conducting sheet with a thickness of 3 mm.

### Comparison embodiment 3

A sizing material is prepared by using the same method in Embodiment 3, the sizing material is loaded into a common flat mold, the sizing material is pressurized for vulcanization (10 Mpa, 120°C, and 120s), and sheet formation is performed to obtain a heat-conducting sheet with a thickness of 3 mm.

### Embodiment 4

A forming process of an oriented flexible heat-conducting material includes the following steps:
feeding 100 parts of vinyl group-capped polysiloxane, 5 parts of white carbon black prepared by using a precipitation method, 3 parts of silicon-hydrogen bond-containing polysiloxane, and 0.2 part of alkynyl cyclohexanol into a kneading machine, performing kneading evenly, then adding 0.1 part of platinum catalyst and 50 parts of expanded graphite and performing kneading evenly to obtain a sizing material, taking out the sizing material, loading the sizing material into an oriented forming mold, closing an upper mold plate, simultaneously applying pressures in two opposite directions parallel to the mold plate for forming, where the applying is 20 MPa and a time of 3 min is lasted for, then heating the sizing material for vulcanization (120°C, 70 min), and withdrawing the sizing material from a movable mold strip, opening the upper mold plate, and taking out a vulcanized sample on which orientation forming is performed, to obtain the oriented flexible heat-conducting material.

Preparation of a heat-conducting sheet: cutting the obtained oriented flexible heat-conducting material sample by using a cutter (with a V-shaped cutting edge) along a direction parallel to a mold pressing direction to obtain an oriented flexible heat-conducting sheet with a thickness of 3 mm.

### Embodiment 5

A forming process of an oriented flexible heat-conducting material includes the following steps:
feeding 100 parts of vinyl group-capped polysiloxane, 5 parts of white carbon black prepared by using a precipitation method, 5 parts of carbon fibers, 2 parts of silicon-hydrogen bond-containing polysiloxane, and 0.2 part of alkynyl cyclohexanol into a kneading machine, performing kneading evenly, then adding 0.1 part of platinum catalyst and 45 parts of expanded graphite and performing kneading evenly to obtain a sizing material, taking out the sizing material, loading the sizing material into an oriented forming mold, closing an upper mold plate, simultaneously applying pressures in two opposite directions parallel to the mold plate for forming, where the applying pressure is 40 MPa and a time of 2 min is lasted for, then heating the sizing material for vulcanization (120°C, 75 min), and withdrawing the sizing material from a movable mold strip, opening the upper mold plate, and taking out a vulcanized sample on which orientation forming is performed, to obtain the oriented flexible heat-conducting material.

Preparation of a heat-conducting sheet: cutting the obtained oriented flexible heat-conducting material sample by using a cutter (with a V-shaped cutting edge) along a direction parallel to a mold pressing direction to obtain an oriented flexible heat-conducting sheet with a thickness of 3 mm.

### Embodiment 6

A forming process of an oriented flexible heat-conducting material includes the following steps:
feeding 100 parts of vinyl group-capped polysiloxane, 8 parts of white carbon black prepared by using a precipitation method, 2 parts of graphene nanosheets, 2 parts of silicon-hydrogen bond-containing polysiloxane, and 0.2 part of alkynyl cyclohexanol into a kneading machine, performing kneading evenly, then adding 0.1 part of platinum catalyst and 45 parts of expanded graphite and performing kneading evenly to obtain a sizing material, taking out the sizing material, loading the sizing material into an oriented forming mold, closing an upper mold plate, simultaneously applying pressures in two opposite directions parallel to the mold plate for forming, where the applying pressure is 10 MPa and a time of 2 min is lasted for, then heating the sizing material for vulcanization (120°C, 75 min), and withdrawing the sizing material from a movable mold strip, opening the upper mold plate, and taking out a vulcanized sample on which orientation forming is performed, to obtain the oriented flexible heat-conducting material.

Preparation of a heat-conducting sheet: cutting the obtained oriented flexible heat-conducting material sample by using a cutter (with a V-shaped cutting edge) along a direction parallel to a mold pressing direction to obtain an oriented flexible heat-conducting sheet with a thickness of 3 mm.

### Embodiment 7

A forming process of an oriented flexible heat-conducting material includes the following steps:
feeding 100 parts of vinyl group-capped polysiloxane, 5 parts of white carbon black prepared by using a precipitation method, 5 parts of boron nitride nanosheets, 2 parts of silicon-hydrogen bond-containing polysiloxane, and 0.2 part of alkynyl cyclohexanol into a kneading machine, performing kneading evenly, then adding 0.1 part of platinum catalyst and 45 parts of expanded graphite and performing kneading evenly to obtain a sizing material, taking out the sizing material, loading the sizing material into an oriented forming mold, closing an upper mold plate, simultaneously applying pressures in two opposite directions parallel to the mold plate for forming, where the applying pressure is 10 MPa and a time of 2 min is lasted for, then heating the sizing material for vulcanization (120°C, 75 min), and withdrawing the sizing material from a movable mold strip, opening the upper mold plate, and taking out a vulcanized sample on which orientation forming is performed, to obtain the oriented flexible heat-conducting material.

Preparation of a heat-conducting sheet: cutting the obtained oriented flexible heat-conducting material sample by using a cutter (with a V-shaped cutting edge) along a direction parallel to a mold pressing direction to obtain an oriented flexible heat-conducting sheet with a thickness of 3 mm.

### Embodiment 8

A forming process of an oriented flexible heat-conducting material includes the following steps:
feeding 100 parts of vinyl group-capped polysiloxane, 5 parts of white carbon black prepared by using a precipitation method, 2 parts of graphene nanosheets, 3 parts of boron nitride nanosheets, 2 parts of silicon-hydrogen bond-containing polysiloxane, and 0.2 part of alkynyl cyclohexanol into a kneading machine, performing kneading evenly, then adding 0.1 part of platinum catalyst and 45 parts of expanded graphite and performing kneading evenly to obtain a sizing material, taking out the sizing material, loading the sizing material into an oriented forming mold, closing an upper mold plate, simultaneously applying pressures in two opposite directions parallel to the mold plate for forming, where the applying pressure is 10 MPa and a time of 2 min is lasted for, then heating the sizing material for vulcanization (120°C, 75 min), and withdrawing the sizing material from a movable mold strip, opening the upper mold plate, and taking out a vulcanized sample on which orientation forming is performed, to obtain the oriented flexible heat-conducting material.

Preparation of a heat-conducting sheet: cutting the obtained oriented flexible heat-conducting material sample by using a cutter (with a V-shaped cutting edge) along a direction parallel to a mold pressing direction to obtain an oriented flexible heat-conducting sheet with a thickness of 3 mm.

### Effect embodiment

The following performance tests are performed on heat-conducting sheets prepared in Embodiments 1 to 8 and Comparison embodiments 1 to 3 in the present invention:
1. Density: a density balance is used for testing.
2. Hardness: a Shore OO hardness tester is used for testing.
3. Thermal resistance and heat conductivity coefficient: a thermal resistance tester is used for testing according to the ASTM D5470 standard.

Test results are shown in Table 1:

**Table 1**

| | **Density g/cm³** | **Hardness (Shore OO)** | **Thermal resistance (°C·in²/W)** | **Heat conductivity coefficient (W/m·k)** |
|---|---|---|---|---|
| Embodiment 1 | 1.204 | 72 | 0.49 | 15.38 |
| Embodiment 2 | 1.154 | 60 | 0.48 | 15.69 |
| Embodiment 3 | 1.234 | 45 | 0.46 | 16.31 |
| Embodiment 4 | 1.035 | 40 | 0.45 | 16.38 |
| Embodiment 5 | 1.117 | 30 | 0.57 | 14.85 |
| Embodiment 6 | 1.120 | 35 | 0.49 | 15.12 |
| Embodiment 7 | 1.207 | 40 | 0.54 | 14.84 |
| Embodiment 8 | 1.188 | 40 | 0.59 | 14.32 |
| Comparison embodiment 1 | 1.326 | 75 | 1.21 | 3.99 |
| Comparison embodiment 2 | 1.275 | 63 | 1.01 | 4.76 |
| Comparison embodiment 3 | 1.316 | 57 | 1.12 | 4.05 |

It can be seen from the test results in Table 1 that, compared with the comparison embodiments, for the oriented flexible heat-conducting sheet prepared by an oriented forming process in the embodiments of the present invention, the heat-conducting property of the oriented flexible heat-conducting sheet is greatly enhanced, where the heat conductivity coefficient can reach above 15 W/(m·k), and the interface thermal resistance is also obviously reduced. Therefore, the oriented flexible heat-conducting sheet provided in the embodiments of the present invention can be used in a heat dissipation cooling apparatus of a heat generating component, and can greatly improve a heat dissipation effect.

## Claims

1. An oriented flexible heat-conducting material, wherein main ingredients of the oriented flexible heat-conducting material are silicone rubber and anisotropic heat-conducting filler, multiple continuous heat-conducting paths that are parallel to each other are formed in the oriented flexible heat-conducting material, and the heat-conducting paths are formed by continuously arranging the anisotropic heat-conducting filler, filled in the silicone rubber, in lines in a heat-conducting path direction.

2. The oriented flexible heat-conducting material according to claim 1, wherein the silicone rubber comprises a component A and a component B, wherein:
the component A comprises polysiloxane containing two or more unsaturated bonds, wherein the unsaturated bonds are allyl groups or vinyl groups; and
the component B comprises polysiloxane containing two or more silicon-hydrogen bonds.

3. The oriented flexible heat-conducting material according to claim 2, wherein corresponding parts by weight of components of the oriented flexible heat-conducting material are that:
for the silicone rubber, the component A is 100 parts by weight, and the component B is 2 to 5 parts by weight; and
the anisotropic heat-conducting filler is 10 to 70 parts by weight.

4. The oriented flexible heat-conducting material according to any one of claims 1 to 3, wherein the oriented flexible heat-conducting material further comprises one or more of the following materials:
a precious metal catalyst, an inhibitor, reinforcing filler used for improving a comprehensive mechanical property of the oriented flexible heat-conducting material, and an inorganic powder material used for enhancing a comprehensive heat-conducting property of the oriented flexible heat-conducting material.

5. The oriented flexible heat-conducting material according to claim 4, wherein corresponding parts by weight of the precious metal catalyst, the inhibitor, the reinforcing filler and the inorganic powder material in the oriented flexible heat-conducting material are that:
the reinforcing filler is 0.1 to 8 parts by weight;
the precious metal catalyst is 0.1 to 7 parts by weight;
the inhibitor is 0.1 to 5 parts by weight; and
the inorganic powder material is 1 to 20 parts by weight.

6. The oriented flexible heat-conducting material according to claim 5, wherein the reinforcing filler used for improving the comprehensive mechanical property of the oriented flexible heat-conducting material is white carbon black produced by using a precipitation method or white carbon black produced by a vapor phase method.

7. The oriented flexible heat-conducting material according to claim 5, wherein the inorganic powder material used for enhancing the comprehensive heat-conducting property of the oriented flexible heat-conducting material is one or more of aluminum oxide, silicon dioxide, zinc oxide, boron nitride, silicon nitride, and silicon carbide.

8. The oriented flexible heat-conducting material according to claim 5, wherein the precious metal catalyst is a platinum catalyst.

9. The oriented flexible heat-conducting material according to claim 5, wherein the inhibitor is an acetylenic alcohol inhibitor.

10. The oriented flexible heat-conducting material according to any one of claims 1 to 3, wherein the anisotropic heat-conducting filler is one or more of expanded graphite, carbon fibers, carbon nanotubes, graphene nanosheets, and boron nitride nanosheets.

11. The oriented flexible heat-conducting material according to any one of claims 1 to 3, wherein a compression ratio of the cured silicone rubber is higher than 80%, and a crosslinking density of the cured silicone rubber is 0 to 70%.

12. A forming process of an oriented flexible heat-conducting material, comprising the following steps:
evenly mixing silicone rubber and anisotropic heat-conducting filler to form a sizing material, adding the sizing material into an oriented forming mold, applying a pressure in a direction perpendicular to a preset heat-conducting path, and then performing heating to vulcanize the sizing material, so as to obtain the oriented flexible heat-conducting material, wherein in the oriented flexible heat-conducting material, multiple continuous heat-conducting paths that are parallel to each other are formed in a direction along the preset heat-conducting path, and the heat-conducting paths are formed by continuously arranging the anisotropic heat-conducting filler, filled in the silicone rubber, in lines in the direction along the preset heat-conducting path.

13. The forming process of an oriented flexible heat-conducting material according to claim 12, wherein a mold strip, in the direction along the preset heat-conducting path, of the oriented forming mold is a movable mold strip.

14. An oriented flexible heat-conducting sheet obtained by cutting the oriented flexible heat-conducting material according to any one of claims 1 to 11, wherein multiple continuous heat-conducting paths that are parallel to each other exist in a thickness direction of the oriented flexible heat-conducting sheet, and the heat-conducting paths are formed by continuously arranging anisotropic heat-conducting filler, filled in the silicone rubber, in lines in a heat-conducting path direction.

15. A heat dissipation system, comprising a heat generating element, a radiator and a heat-conducting sheet, wherein the heat-conducting sheet is the oriented flexible heat-conducting sheet according to claim 14, the heat generating element is located on one side of the radiator, and the heat-conducting sheet is located between the heat generating element and the radiator in close contact, so that the heat generating element transfers, by using the heat-conducting sheet, heat to the radiator to dissipate the heat.
